# EUROPÄISCHE PATENTSCHRIFT

(11) **EP 2 399 303 B1**
(45) Veröffentlichungstag und Bekanntmachung des Hinweises auf die Patenterteilung: **18.03.2015**
(21) Anmeldenummer: 10701522.4
(22) Anmeldetag: 27.01.2010
(51) Int. Cl.: H01L 35/32, F01N 5/02

(54) **THERMOELEKTRISCHE VORRICHTUNG**
THERMOELECTRIC DEVICE
DISPOSITIF THERMOELECTRIQUE

(30) Priorität: 19.02.2009 DE 102009009586
(43) Veröffentlichungstag der Anmeldung: 28.12.2011
(73) Patentinhaber: Emitec Gesellschaft für Emissionstechnologie mbH, 53797 Lohmar (DE)
(72) Erfinder: LIMBECK, Sigrid, 53804 Much (DE); BRÜCK, Rolf, 51429 Bergisch Gladbach (DE)
(74) Vertreter: Rössler, Matthias
(86) Internationale Anmeldenummer: PCT/EP2010/050884
(87) Internationale Veröffentlichungsnummer: WO 2010/094533

(56) Entgegenhaltungen:
- DE-A1-102006 039 024
- DE-C- 669 966
- GB-A- 874 660
- US-A- 3 243 869
- US-A- 4 095 998
- US-A- 6 096 966

## Beschreibung

Die vorliegende Erfindung betrifft eine thermoelektrische Vorrichtung zur Erzeugung elektrischer Energie, z. B. aus dem Abgas einer Verbrennungskraftmaschine, mittels eines Generators. Damit ist insbesondere ein Generator zur Umwandlung thermischer Energie eines Abgases in elektrische Energie gemeint, also ein sogenannter thermoelektrischer Generator.

Das Abgas aus einem Motor eines Kraftfahrzeuges besitzt thermische Energie, welche mittels eines thermoelektrischen Generators bzw. Apparates in elektrische Energie umgewandelt werden kann, um bspw. eine Batterie oder einen anderen Energiespeicher zu füllen oder elektrischen Verbrauchern die benötigte Energie direkt zuzuführen. Damit wird das Kraftfahrzeug mit einem besseren energetischen Wirkungsgrad betrieben, und es steht für den Betrieb des Kraftfahrzeuges Energie in größerem Umfang zur Verfügung.

Ein solcher thermoelektrischer Generator weist zumindest eine Mehrzahl thermoelektrischer Wandlerelemente auf. Thermoelektrische Materialien sind von einer Art, dass diese effektiv thermische Energie in elektrische Energie umwandeln können (Seebeck-Effekt) und umgekehrt (Peltier-Effekt). Der "Seebeck-Effekt" basiert auf dem Phänomen der Umwandlung von Wärmeenergie in elektrische Energie und wird zur Erzeugung thermoelektrischer Energie genutzt. Der "Peltier-Effekt" ist die Umkehrung des "Seebeck-Effektes" und ein Phänomen, welches mit Wärmeadsorption einhergeht und in Relation zu einem Stromfluss durch unterschiedliche Materialien verursacht wird. Der "Peltier-Effekt" ist bspw. zum thermoelektrischen Kühlen bereits vorgeschlagen worden.

Solche thermoelektrischen Wandlerelemente weisen bevorzugt eine Vielzahl von thermoelektrischen Elementen auf, die zwischen einer sogenannten Heißseite und einer sogenannten Kaltseite positioniert sind.

Thermoelektrische Elemente umfassen z. B. wenigstens zwei Halbleiterquader (p- und n-dotiert), die auf ihrer Ober- und Unterseite (hin zur Heißseite bzw. Kaltseite) wechselseitig mit elektrisch leitenden Brücken versehen sind. Keramikplatten bzw. Keramikbeschichtungen und/oder ähnliche Materialien dienen zur Isolierung der Metallbrücken und sind somit bevorzugt zwischen den Metallbrücken angeordnet. Wird ein Temperaturgefälle beidseits der Halbleiterquader bereitgestellt, so bildet sich ein Spannungspotential aus. Auf der Heißseite des ersten Halbleiterquaders wird dabei Wärme aufgenommen, wobei die Elektronen der einen Seite auf das energetisch höherliegende Leitungsband des folgenden Quaders gelangen. Auf der Kaltseite können die Elektronen nun Energie freisetzen und auf den folgenden Halbleiterquader mit niedrigerem Energieniveau gelangen. Somit kann sich bei einem entsprechenden Temperaturgefälle ein elektrischer Stromfluss einstellen.

Es ist bereits versucht worden, entsprechende thermoelektrische Generatoren für die Anwendung in Kraftfahrzeugen, insbesondere Personenkraftfahrzeugen, bereitzustellen. Diese waren jedoch meist sehr teuer in der Herstellung und gekennzeichnet durch einen relativ geringen Wirkungsgrad. Damit konnte noch keine Serientauglichkeit erlangt werden. Außerdem konnte festgestellt werden, dass die bekannten thermoelektrischen Generatoren meist sehr großen Bauraum verlangen und deshalb nur schwer in die bestehenden Abgasanlagen integriert werden können.

Die US 4,095,998 ist auf ein zylinderförmiges thermoelektrisches Modul gerichtet, das in einem ringförmigen Zwischenraum quaderförmige thermoelektrische Elemente aufweist, die in Umfangsrichtung und in axialer Richtung wechselweise angeordnet und elektrisch leitend miteinander verbunden sind. Es werden dort quaderförmige Halbleiterelemente mit gleichgroßen Kontaktflächen offenbart.

US-A-3,243,869 offenbart einen zylinderförmigen thermoelektrischen Generator mit ringförmigen thermoelektrischen Elementen. Diese sind durch Isolationsringe voneinander in axialer Richtung getrennt. Die elektrischen Verbindungen werden über ringförmige Elemente erzeugt.

Aus GB-A-874,660 ist ein zylinderförmiger thermoelektrischer Generator mit quaderförmigen thermoelektrischen Halbleiterelementen bekannt.

Die DE-C-669 966 offenbart eine Thermosäule, bei der Thermometalle dachziegelartig aufeinander gelegt werden, um eine Effizienz der Thermosäule zu erhöhen.

Hiervon ausgehend ist es Aufgabe der vorliegenden Erfindung, die mit Bezug auf den Stand der Technik geschilderten Probleme zumindest teilweise zu lösen. Insbesondere soll eine thermoelektrische Vorrichtung angegeben werden, die für vielseitige Einsatzfälle geeignet ist und die einen verbesserten Wirkungsgrad hinsichtlich der Umwandlung von bereitgestellter thermischer Energie in elektrische Energie ermöglicht. Dabei soll die thermoelektrische Vorrichtung geeignet sein, möglichst flexibel an unterschiedliche Leistungsanforderungen angepasst zu werden.

Diese Aufgaben werden gelöst mit einer Vorrichtung gemäß den Merkmalen des Patentanspruchs 1. Vorteilhafte Ausgestaltungen der erfindungsgemäßen Vorrichtung sowie die Integration dieser Vorrichtung in übergeordnete Baueinheiten sind in den abhängig formulierten Patentansprüchen angegeben. Es ist darauf hinzuweisen, dass die in den Patentansprüchen einzeln aufgeführten Merkmale in beliebiger, technologisch sinnvoller, Weise miteinander kombiniert werden können und weitere Ausgestaltungen der Erfindung aufzeigen. Die Beschreibung, insbesondere im Zusammenhang mit den Figuren, erläutert die Erfindung weiter und führt ergänzende Ausführungsbeispiele der Erfindung an.

Die erfindungsgemäße thermoelektrische Vorrichtung weist zumindest Folgendes auf:
- wenigstens ein Modul mit einer ersten Trägerschicht und einer zweiten Trägerschicht,
- einen Zwischenraum zwischen der ersten Trägerschicht und der zweiten Trägerschicht,
- eine elektrische Isolationsschicht auf der ersten Trägerschicht und auf der zweiten Trägerschicht hin zum Zwischenraum,
- eine Mehrzahl von p- und n-dotierten Halbleiterelementen, die im Zwischenraum zwischen den Isolationsschichten abwechselnd angeordnet und wechselweise elektrisch miteinander verbunden sind.

Erfindungsgemäß sind die p- und n-dotierten Halbleiterelemente auf der elektrischen Isolationsschicht durch ein Lotmaterial miteinander elektrisch verbunden, wobei die p- und n- dotierten Halbleiterelemente jeweils gleich große Stromübergangsflächen aufweisen.

Die hier vorgeschlagene thermoelektrische Vorrichtung ist insbesondere lagenweise bzw. schichtartig mit insbesondere einer Mehrzahl von (gleichen) Modulen zu einem thermoelektrischen Generator zusammengesetzt. Insbesondere bilden mehrere miteinander verbundene Module eine thermoelektrische Vorrichtung. Dabei ist die thermoelektrische Vorrichtung insbesondere in einem Gehäuse angeordnet, in dem auch mehrere thermoelektrische Vorrichtungen zusammen als Baueinheit zur Bildung eines thermoelektrischen Generators angeordnet sein können. Die thermoelektrische Vorrichtung weist zusätzlich zu dem Modul insbesondere Abdichtungsmittel auf, die den Zwischenraum nach außen abschließen, sowie Anschlusselemente zur Erzeugung eines elektrischen Stromkreises, der den im Modul erzeugten elektrischen Strom an einen Speicher oder Verbraucher eines Kraftfahrzeuges leiten kann.

Die Halbleiterelemente sind insbesondere nebeneinander zwischen zwei Trägerschichten angeordnet, die insbesondere die äußere Begrenzung der thermoelektrischen Vorrichtung bilden. Die äußeren Trägerschichten bilden dabei in erster Linie eine Wärmeübergangsschicht, die einen Wärmeübergang von der thermoelektrischen Vorrichtung zu den die thermoelektrische Vorrichtung umströmenden Fluiden ermöglicht. Dabei ist die erste/zweite Trägerschicht mit einer sogenannten Heißseite, insbesondere einem Fluid mit erhöhter Temperatur, und die andere (zweite/erste) Trägerschicht mit einer Kaltseite, insbesondere mit einem Fluid niedriger Temperatur, in wärmeleitender Verbindung. Dadurch wird über die thermoelektrische Vorrichtung ein Temperaturpotential zwischen den Trägerschichten ausgebildet, das in Folge des "Seebeck-Effektes" einen elektrischen Strom durch die wechselweise miteinander verbundenen Halbleiterelemente erzeugt. Die Trägerschichten sind insbesondere wenigstens zum Teil aus Stahl und/oder Aluminium aufgebaut.

Zwischen den Trägerschichten ist ein Zwischenraum vorgesehen, in dem die Halbleiterelemente angeordnet sind. Der Zwischenraum weist damit insbesondere nur eine Ausdehnung auf, die im Wesentlichen nur durch eine Höhe und eine Anzahl sowie durch die Anordnung der Halbleiterelemente vorgegeben ist.

Zur Realisierung eines gezielten Stromflusses durch die p- und n-dotierten Halbleiterelemente weisen die Trägerschichten zumindest teilweise eine elektrische Isolationsschicht auf, auf der die Halbleiterelemente fixiert und miteinander elektrisch verbunden sind. Als Isolationsschicht kommt insbesondere eine Aluminiumoxidschicht in Betracht. Bei der elektrischen Isolationsschicht ist darauf zu achten, dass diese den Wärmeübergang von einer Außenseite der Trägerschicht hin zu den Halbleiterelementen nicht übermäßig behindert. Das kann insbesondere auch dadurch erreicht werden, dass die elektrische Isolationsschicht tatsächlich nur im Bereich der Kontaktfläche der Halbleiterelemente mit der Trägerschicht vorgesehen ist. Jedenfalls ist eine solche elektrische Isolationsschicht so dicht auszuführen, dass sie für das elektrische Verbindungsmittel der Halbleiterelemente untereinander nicht durchdringbar ist, und die elektrische Isolationsschicht sicher elektrisch leitende Verbindungen hin zu der Trägerschicht und/oder zu benachbarten Strompfaden verhindert. Bei den ersten und zweiten Trägerschichten sind insbesondere unterschiedliche elektrische Isolationsschichten möglich.

Als leitfähige Materialien für die p-dotierten und n-dotierten Halbleiterelemente kann beispielsweise Wismut-Tellurit (Bi2Te3) eingesetzt werden. Darüber hinaus könnten folgende Materialien [bis zu folgenden maximalen Temperaturen in °C] eingesetzt werden:

| | | |
|---|---|---|
| n-Typ: | Bi₂Te₃ | [ca. 250 °C]; |
| | PbTe | [ca. 500 °C]; |
| | Ba_{0,3}Co_{3,95}Ni_{0,05}Sb₁₂ | [ca. 600 °C]; |
| | Ba_{y}(Co,Ni)₄Sb₁₂ | [ca. 600 °C]; |
| | CoSb₃ | [ca. 700 °C]; |
| | Ba₈Ga₁₆Ge₃₀ | [ca. 850 °C]; |
| | La₂Te₃ | [ca. 1100 °C]; |
| | SiGe | [ca. 1000 °C]; |
| | Mg₂(Si,Sn) | [ca. 700 °C]; |
| p-Typ: | (Bi,Sb)₂TE₃ | [ca. 200 °C]; |
| | Zn₄Sb₃ | [ca. 380 °C]; |
| | TAGS | [ca. 600°C]; |
| | PbTe | [ca. 500 °C]; |
| | SnTe | [ca. 600 °C]; |
| | CeFe₄Sb₁₂ | [ca. 700 °C]; |
| | Yb₁₄MnSb₁₁ | [ca. 1000 °C]; |
| | SiGe | [ca. 1000 °C]; |
| | Mg₂(Si,Sb) | [ca. 600 °C]. |

Bei dieser thermoelektrischen Vorrichtung werden also die zwei Trägerschichten zur Begrenzung des Zwischenraums genutzt und für einen

Wärmeübergang hin zu den Halbleiterelementen. Die Halbleiterelemente können dabei bspw. nach Art von kleinen Quadern und/oder kleinen länglichen Stäbchen aus unterschiedlich elektrisch leitfähigem Material bereitgestellt sein. Jeweils zwei unterschiedliche Halbleiterelemente (p-dotiert und n-dotiert) sind so miteinander elektrisch verbunden, dass sie zusammen eine Reihenschaltung ergeben. Eine der beiden Trägerschichten nimmt den einfließenden Wärmestrom auf (Heißseite), während die andere Trägerschicht den ausfließenden Wärmestrom abgibt (Kaltseite). Im Hinblick auf das Design der Anordnung bzw. Verschaltung der einzelnen Halbleiterelemente können Art und/oder Gestalt und/oder Position der Halbleiterelemente an den Bauraum, den Wärmefluss, die Stromführung etc. angepasst sein, wobei sie sich insbesondere auch hierbei unterscheiden können. Insbesondere weist die thermoelektrische Vorrichtung eine oder mehrere Gruppen von miteinander in Reihe geschalteten Halbleiterelementen auf, wobei die Gruppen jeweils voneinander unabhängige Stromkreise aufweisen oder miteinander über eine elektrische Parallelschaltung verbunden sind.

Gemäß einer Weiterbildung der thermoelektrischen Vorrichtung umfasst das Material für die wenigstens eine Trägerschicht einen Kunststoff. Hier können insbesondere Kunststoffe eingesetzt werden, die auch metallische Einschlüsse zur Verbesserung der Wärmeleitung aufweisen. Insbesondere sind hier Kunststoffe angesprochen, die für Temperaturbereiche von 200 bis 390 °C geeignet sind und eine hohe Dauerfestigkeit aufweisen. Bevorzugt können die Kunststoffe auf ihrer äußeren (vom Zwischenraum wegweisenden) Oberfläche eine Beschichtung aufweisen, die insbesondere gegenüber einem die Trägerschicht überströmenden korrosivem Medium beständig ausgeführt ist. Der Einsatz von Kunststoff ist hier insbesondere von Vorteil, da Kunststoffe kostengünstig bereitgestellt werden können, flexibel herstellbar sind, an unterschiedliche Anforderungen flexibel anpassbar und mit unterschiedlichsten Fertigungsverfahren herstellbar und bearbeitbar sind. Insbesondere werden hier Polyetherketone (z.B. PEKK) als Kunststoff zum Einsatz für die Trägerschichten vorgeschlagen, da diese hochtemperaturbeständig sind und Schmelztemperaturen von über 300°C aufweisen und gleichzeitig gegen viele organische und anorganische Chemikalien beständig sind. Damit sind sie insbesondere auch ohne zusätzliche Beschichtung als Trägerschichten einzusetzen.

Bei der erfindungsgemäßen thermoelektrischen Vorrichtung sind die Halbleiterelemente kreisringförmig ausgestaltet und jeweils mit einer äußeren Umfangsfläche und einer inneren Umfangsfläche mit der elektrischen Isolationsschicht verbunden. Der Begriff "kreisringförmig" meint damit, dass das Halbleiterelement zumindest einen Abschnitt eines Kreisrings bildet. Derartig geformte Halbleiterelemente sind insbesondere für zumindest teilweise rohrförmige thermoelektrische Vorrichtungen vorzuschlagen. Dabei bilden die Trägerschichten die äußere Umfangsfläche und die innere Umfangsfläche eines Rohres, so dass eine Doppelrohrwand gebildet ist, in dessen Zwischenraum die Halbleiterelemente angeordnet sind. Eine derart aufgebaute thermoelektrische Vorrichtung wird von einem Fluid durch einen von der inneren Umfangsfläche des Rohres gebildeten Kanal durchströmt und von einem anderen Fluid auf der äußeren Umfangsfläche überströmt, so dass ein Temperaturpotential über die Doppelrohrwand erzeugbar ist. Die Halbleiterelemente sind innerhalb der Doppelrohrwand angeordnet und insbesondere umlaufend geschlossen in Form eines Kreisringes ausgeführt. Die Halbleiterelemente können insbesondere auch die Form eines Kreisringsegmentes aufweisen. Auch hier sind die Halbleiterelemente nebeneinander bzw. hintereinander entlang einer axialen Richtung des Rohres angeordnet. Eine kreisringförmige bzw. kreisringsegmentförmige Ausgestaltung der Halbleiterelemente ist bevorzugt, da zwischen nebeneinander angeordneten zylindrischen oder quaderförmigen Halbleiterelementen auf einer gebogenen Fläche Spalte zwischen den Halbleiterelementen erzeugt werden, die in radialer Richtung sich erweitern und damit eine geringere Volumenausnutzung des Zwischenraums gegeben ist. Die Kreisringform kann dabei insbesondere einer Kreisform entsprechen, es sind aber ovale Ausführungsformen möglich. Im Hinblick auf die Verschaltung hier beispielsweise auch möglich, dass die Halbleiterelemente eine 180°-Kreisringform aufweisen, die dann versetzt/abwechselnd miteinander elektrisch verbunden sind.

Gemäß einer vorteilhaften Weiterbildung der thermoelektrischen Vorrichtung sind die p- und n-dotierten Halbleiterelemente auf der elektrischen Isolationsschicht durch ein Lotmaterial miteinander elektrisch verbunden, wobei zumindest eine der folgenden Bedingungen erfüllt ist:
das Lotmaterial weist eine Lotdicke auf und das Verhältnis von einer Höhe der Halbleiterelemente zu der Lotdicke ist größer als 5: 1;
das Lotmaterial ist ein Element aus der Gruppe Aktivlot, Silberlot.

Bevorzugt ist dabei, dass die zur Fixierung der Halbleiterelemente dienenden Lötpunkte bzw. Lötflächen die Kontaktfläche der Halbleiterelemente mit der Isolationsschicht nicht überschreitet. Das Lotmaterial wird bevorzugt dadurch aufgebracht, dass auf die elektrische Isolationsschicht an den gewünschten Stellen ein Haftmittel aufgedruckt wird, um die Trägerschichten dann mit pulverförmigem Lotmaterial in Kontakt zu bringen, welches an diesen vorgegebenen Haftmittelstellen haften bleibt. Die Körnung des Lotmaterials ist dabei so zu wählen, dass genau soviel Lotmaterial zur Verfügung gestellt wird, dass die gewünschte durch das Lotmaterial gebildete Kontaktfläche ausgebildet wird. Dabei weisen die Halbleiterelemente auf jeder ihrer Kontaktflächen gleich große Stromübergangsflächen auf, welche durch die mit Lotmaterial versehenen Bereiche der Kontaktflächen des Halbleiterelementes definiert sind. Dadurch werden möglichst identische Übergangswiderstände zwischen den Halbleiterelementen und den als Leiterbahn fungierenden Lotmaterialien erreicht. Insbesondere bei kreisringförmig oder kreisringsegmentförmig ausgestalteten Halbleiterelementen sowie bei Halbleiterelementen mit unterschiedlich großen Kontaktflächen ist vorgesehen, gleich große Stromübergangsflächen vorzusehen. Dabei ist die äußere Umfangsfläche des Halbleiterelementes regelmäßig größer als die innere Umfangsfläche. Dementsprechend können die äußeren Stromübergangsflächen schmaler ausgeführt sein gegenüber den Stromübergangsflächen, die an der inneren Umfangsfläche der Halbleiterelemente angeordnet sind. Dies ist insbesondere vorteilhaft für den Herstellungsprozess der thermoelektrischen Vorrichtung, bei der die Positionierung der Leiterbahnen auf der einen Trägerschicht mit den Leiterbahnen auf der anderen Trägerschicht derart abgestimmt sind, dass eine wechselweise elektrische Verbindung der Halbleiterelemente erreicht wird, so dass eine Reihenschaltung durch die thermoelektrische Vorrichtung erzeugbar ist. Die somit mögliche Reduzierung der Breite der Stromübergangsfläche ermöglicht daher die Aufweitung der Fertigungstoleranzen bei der Herstellung der Leiterbahnen durch das Aufbringen von Lotmaterial und bei der Montage der einzelnen Komponenten. Somit können Herstellungsfehler und Herstellungskosten in der Produktion der vorgeschlagenen thermoelektrischen Vorrichtung in deutlichem Maße reduziert werden.

Die eingesetzten Halbleiterelemente weisen bevorzugt eine Höhe von 1 bis 5 mm auf. Dies führt zu einer besonders kompakten Ausgestaltung der thermoelektrischen Vorrichtung und gewährleistet auch eine ausreichende Temperaturdifferenz zwischen den Trägerschichten über den Zwischenraum hinweg. Regelmäßig werden alle Halbleiterelemente die gleiche Höhe aufweisen. Dabei beträgt das Verhältnis der Höhe der Halbleiterelemente zu der Lotdicke insbesondere mehr als 10 zu 1, bevorzugt mehr als 20 zu 1 und besonders bevorzugt mehr als 50 zu 1. Durch die Begrenzung der Lotdicke wird ebenfalls eine kompakte Bauform der thermoelektrischen Vorrichtung gefördert.

Bevorzugt ist das Lotmaterial aus der Gruppe Aktivlot, Silberlot und insbesondere aus den Lotmaterialien gemäß der Europäischen Norm EN 1044 : 1999 auszuwählen: AG301, AG302, AG303, AG304, AG305, AG306, AG307, AG308, AG309, AG351, AG401, AG402, AG403, AG501, AG502, AG503, AG101, AG102, AG103, AG104, AG105, AG106, AG107, AG108, AG201, AG202, AG203, AG204, AG205, AG206, AG207, AG208. Ggf. können unter Berücksichtigung des Anwendungsfalls selbstverständlich auch andere auf die Halbleitermaterialien abgestimmte, hochtemperaturbeständige Lote eingesetzt werden.

Gemäß einer vorteilhaften Weiterbildung der thermoelektrischen Vorrichtung sind eine erste Kontaktfläche zwischen der ersten Trägerschicht und dem Halbleiterelement und eine zweite Kontaktfläche zwischen der zweiten Trägerschicht und dem Halbleiterelement über die elektrische Isolationsschicht unterschiedlich groß und weisen ein Verhältnis der ersten Kontaktfläche zu der zweiten Kontaktfläche von bis zu 1 : 3 auf. Dabei sind die erste Kontaktfläche und die zweite Kontaktfläche jeweils definiert als die Fläche des Halbleiterelementes, die mit der ersten bzw. zweiten Trägerschicht über die elektrische Isolationsschicht oder über das Lotmaterial verbunden ist. Durch die unterschiedliche Ausführung der ersten und zweiten Kontaktfläche wird ebenfalls eine höhere Produktivität der Fertigung der thermoelektrischen Vorrichtung ermöglicht. Hierdurch erhöht sich die für die Kontaktierung durch das Lotmaterial vorgesehene Fläche des Halbleiterelementes, so dass Fertigungstoleranzen großzügiger ausgeführt werden können und dementsprechend eine sichere und fehlerfreie Produktion der thermoelektrischen Vorrichtung gewährleistet ist. Insbesondere weist dabei bei einer rohrförmigen Ausgestaltung des Moduls ein Halbleiterelement eine größere äußere Kontaktfläche auf. Die Halbleiterelemente können dementsprechend eine sich nach außen erweiternde Form (insbesondere eine Konizität) aufweisen, durch die eine derartig unterschiedliche Kontaktfläche gewährleistet ist. Weiterhin kann durch die kreisringförmige bzw. kreisringsegmentförmige Ausbildung des Halbleiterelementes eine derartige Bedingung erfüllt werden. Insbesondere ist die größere Kontaktfläche regelmäßig an der von einem Gasstrom überströmten Trägerschicht angeordnet. Bei der Anordnung der thermoelektrischen Vorrichtung in einem Kraftfahrzeug, bei der die erste Trägerschicht mit einer Heißseite verbunden ist und damit von einem Abgasstrom überströmt wird und bei der die zweite Trägerschicht mit einer Kaltseite verbunden ist und insbesondere von einer Kühlflüssigkeit überströmt wird, ist die erste Kontaktfläche größer als die zweite Kontaktfläche auszubilden. Dies ist durch den höheren Wärmeübergangswiderstand an der von dem Gasstrom überströmten ersten Trägerschicht begründet. Die von der Kühlflüssigkeit überströmte zweite Trägerschicht kann die Wärme besser leiten, so dass hier die kleinere zweite Kontaktfläche vorgesehen werden kann.

Gemäß einer weiteren vorteilhaften Ausgestaltung ist ein Nutzvolumen des Moduls als Verhältnis von der Summe von Volumen der Halbleiterelemente in dem Modul zu einem gekapselten Volumen des Moduls definiert und das Nutzvolumen größer als 90 %. Das gekapselte Volumen des Moduls wird insbesondere durch die äußeren Trägerschichten und ggf. weiteren Wandungen der thermoelektrischen Vorrichtung bzw. des Moduls definiert. Bevorzugt sollte der Zwischenraum zwischen den Trägerschichten daher möglichst vollständig durch die Halbleiterelemente ausgefüllt sein. Das Nutzvolumen sollte daher insbesondere größer 95 % bevorzugt größer 98 % sein. Dies wird insbesondere durch ringförmige Halbleiterelemente erreicht, die in Umfangsrichtung keine Trennebenen aufweisen und dementsprechend ein hohes Nutzvolumen der thermoelektrischen Vorrichtung bzw. des Moduls ermöglichen.

Gemäß einer weiteren vorteilhaften Weiterbildung der thermoelektrischen Vorrichtung weisen die Halbleiterelemente an einander zugewandten Seitenflächen eine elektrische Isolierung auf, wobei die elektrische Isolierung insbesondere durch eine Schicht aus Glimmer oder Keramik gebildet wird. Als Glimmer ist eine Gruppe von Schichtsilicaten bezeichnet. Dabei werden Spalte zwischen den Halbleiterelementen durch Glimmer oder Keramik in Form von Füllmaterial oder in Form einer Beschichtung ausgefüllt. Bevorzugt kann diese Isolierung bereits vor dem Montageprozess der thermoelektrischen Vorrichtung auf die Halbleiterelemente aufgebracht werden, so dass die Halbleiterelemente mit einer hohen Packungsdichte auf den Trägerschichten bzw. elektrischen Isolationsschichten angeordnet werden können und sich gegeneinander abstützen. Ein aus dem Stand der Technik bekannter Luftspalt zwischen den Halbleiterelementen, der sich fertigungstechnisch nur schwer einstellen lässt, ist damit hier nicht nötig. Hier wird die Isolierung der Halbleiterelemente untereinander so durch eine gesonderte Schicht bewirkt, so dass die Halbleiterelemente in Form der Reihenschaltung ausschließlich über die Lotmaterialien elektrisch miteinander verbunden sind. Dabei ist es besonders vorteilhaft, dass die Isolierung zwischen den Seitenflächen der Halbleiterelemente eine Isolierungsweite von weniger als 50 µm aufweist, bevorzugt weniger als 20 µm und besonders bevorzugt weniger als 5 µm. Auch diese Maßnahme führt zu einer kompakten Bauform der thermoelektrischen Vorrichtung und ebenfalls zu einer vereinfachten Herstellung.

Gemäß einer weiteren vorteilhaften Ausgestaltung der thermoelektrischen Vorrichtung ist ein Flächennutzungsgrad des Moduls definiert als das Verhältnis von der mit Halbleiterelementen beschichteten Fläche der ersten und zweiten Trägerschichten zu einer mit Halbleiterelementen beschichtbaren Gesamtfläche der ersten und zweiten Trägerschichten und der Flächennutzungsrad des Moduls größer als 85 %. Auch durch diesen Parameter soll insbesondere die möglichst kompakte Bauform der thermoelektrischen Vorrichtung bzw. des Moduls definiert werden. Die beschichtbare Gesamtfläche der ersten und zweiten Trägerschichten wird dabei durch die an den äußeren Rändern angeordneten Halbleiterelemente begrenzt und berücksichtigt damit die zwischen den Halbleiterelementen vorhandenen elektrisch isolierenden Spalte. Der Flächennutzungsgrad des Moduls ist insbesondere größer als 95 % und insbesondere größer als 98 % auszuführen.

Gemäß einer weiteren vorteilhaften Weiterbildung der thermoelektrischen Vorrichtung weist die elektrische Isolationsschicht zwischen zumindest einer der Trägerschichten und dem Halbleiterelement eine Isolationsschichtdicke von weniger als 70 µm auf. Insbesondere ist diese Isolationsschichtdicke geringer als 50 µm und besonders bevorzugt geringer als 20 µm auszuführen.

Gemäß einer weiteren vorteilhaften Ausgestaltung der thermoelektrischen Vorrichtung ist das Verhältnis einer Höhe der Halbleiterelemente zu einer Isolationsschichtdicke der elektrischen Isolationsschicht größer als 8 : 1, bevorzugt größer als 80 : 1 und besonders bevorzugt größer als 100 : 1. Auch dieser Parameter verdeutlicht die hohe Ausnutzung des vorhandenen Volumens der thermoelektrischen Vorrichtung für die Anordnung von Halbleiterelementen, so dass eine möglichst effektive thermoelektrische Vorrichtung gegeben ist.

Gemäß einer weiteren vorteilhaften Ausgestaltung der thermoelektrischen Vorrichtung weist die erste Trägerschicht eine erste Dicke zwischen 20 µm und 500 um, bevorzugt zwischen 40 µm und 250 µm auf. Dabei ist die erste Trägerschicht während des Betriebes der thermoelektrischen Vorrichtung insbesondere auf der Heißseite angeordnet.

Insbesondere weist nur die erste Trägerschicht zumindest ein axiales Kompensationselement auf, das eine Wärmedehnung des Moduls in einer axialen Richtung ausgleicht. Das axiale Kompensationselement kann z. B. nach Art eines Faltenbalges oder gemäß einer wellenförmigen Ausbuchtung ausgeführt sein, so dass eine Stauchung bzw. Dehnung in diesem Bereich ermöglicht wird und damit die infolge des Temperaturunterschiedes bewirkte unterschiedliche Wärmeausdehnung zwischen der ersten Trägerschicht (Heißseite) und der zweiten Trägerschicht (Kaltseite) kompensiert wird.

Insbesondere ist vorgesehen, dass die zweite Trägerschicht eine zweite Dicke zwischen 200 um und 1,5 mm, insbesondere zwischen 400 µm und 1,2 mm aufweist. Durch diese gegenüber der ersten Dicke wesentlich stärker ausgeführten zweiten Dicke wird die Formstabilität der thermoelektrischen Vorrichtung bzw. des Moduls gewährleistet.

Besonders bevorzugt ist eine thermoelektrische Vorrichtung zumindest aufweisend wenigstens ein Modul mit einer ersten Trägerschicht und einer zweiten Trägerschicht, einen Zwischenraum zwischen der ersten Trägerschicht und der zweiten Trägerschicht, eine elektrische Isolationsschicht auf der ersten Trägerschicht und auf der zweiten Trägerschicht hin zum Zwischenraum, eine Mehrzahl von p- und n-dotierten Halbleiterelementen, die im Zwischenraum zwischen den Isolationsschichten abwechselnd angeordnet und wechselweise elektrisch miteinander verbunden sind, wobei zumindest eine der vorstehen erläuterten Merkmale vorliegen:
1. Das Verhältnis von der Summe von Volumen der Halbleiterelemente in dem Modul zu einem gekapselten Volumen des Moduls führt zu einem Nutzvolumen größer als 90 %.
2. Eine elektrische Isolierung ist mittels einer Schicht bzw. Beschichtung aus Glimmer oder Keramik gebildet.
3. Ein Spalt zwischen den Halbleiterelementen beträgt weniger als 50 µm.
4. Das Verhältnis der Höhe der Halbleiterelemente zur Isolationsschichtdicke ist größer als 8 : 1.
5. Das Lotmaterial weist eine Lotdicke auf und das Verhältnis von einer Höhe der Halbleiterelemente zu der Lotdicke ist größer als 5 : 1 auf.

Besonderes bevorzugt ist auch, dass mindestens 3 oder sogar alle vorstehenden Merkmale in Kombination miteinander verwirklicht sind. Aktuell wird die vorstehende Reihenfolge als Indiz für die Relevanz der Merkmale zur Verbesserung bekannten Vorrichtungen angesehen.

Vorteilhafterweise weist die zweite Trägerschicht ein Material auf, das eine höhere Wärmeleitfähigkeit als die erste Trägerschicht hat, so dass die zweite Trägerschicht trotz der größeren zweiten Dicke dennoch eine vergleichbare Wärmeabführung zeigt.

Gemäß einer weiteren vorteilhaften Weiterbildung der thermoelektrischen Vorrichtung sind mehrere axiale Kompensationselemente in Abständen von jeweils höchstens 10 mm in einer axialen Richtung vorgesehen.

Gemäß einer weiteren vorteilhaften Ausgestaltung weist das wenigstens eine Modul zumindest ein axiales Kompensationselement auf, das gebildet wird durch zumindest mehrere in einer axialen Richtung schräg angeordnete Halbleiterelemente, so dass eine Wärmeausdehnung des Moduls in einer axialen Richtung zumindest teilweise in eine Wärmeausdehnung des Moduls in einer radialen Richtung umgewandelt wird. Durch die Schrägstellung der Halbleiterelemente in einer axialen Richtung kann in Folge einer unterschiedlichen Wärmeausdehnung der ersten Trägerschicht im Vergleich zur zweiten Trägerschicht eine Relativbewegung dieser Trägerschichten durch eine Änderung der Schräglage der Halbleiterelemente kompensiert werden. Dadurch wird anstatt einer einseitigen Längenänderung des Moduls eine radiale Ausdehnung bewirkt. Dabei sind die zumindest mehreren Halbleiterelemente zumindest dann schräg in der axialen Richtung angeordnet, während die thermoelektrische Vorrichtung außer Betrieb ist. Während des Betriebes richten sich die Halbleiterelemente infolge der axialen Wärmeausdehnung so auf, dass die Halbleiterelemente insbesondere senkrecht zu den Trägerschichten bzw. der axialen Richtung angeordnet sind. Diese radiale Wärmeausdehnung kann zu einer Einschränkung eines an die äußeren Trägerschichten angrenzenden, von einem Fluid durchströmten, Querschnitt führen, wobei hierdurch ebenfalls eine Steuerung des Fluid-Volumenstroms entlang der Trägerschichten möglich wird. Dementsprechend können Fluidströme in einem thermoelektrischen Generator mit einer Vielzahl von thermoelektrischen Vorrichtungen und einer Mehrzahl von einem Fluid durchströmten Kanälen bzw. überströmten Trägerschichten insbesondere selbstregelnd gesteuert werden, dass eine gleichmäßige Verteilung der verfügbaren Wärmeleistung im Fluidstrom über alle verfügbaren Oberflächen der thermoelektrischen Vorrichtungen gewähleistet bzw. gefördert wird.

Gemäß einer weiteren vorteilhaften Weiterbildung wird die Kompensation der Wärmeausdehnung durch Materialien für die Trägerschichten bewirkt, die unterschiedliche Wärmeausdehnungskoeffizienten aufweisen. Die Trägerschicht der Heißseite weist einen entsprechend geringen Wärmeausdehnungskoeffizienten auf und die Trägerschicht der Kaltseite einen entsprechend hohen Wärmeausdehnungskoeffizienten.

Eine nicht erfindungsgemäße Ausgestaltung der thermoelektrischen Vorrichtung sieht vor, dass zumindest eine Mehrzahl von Modulen in einer axialen Richtung miteinander verbindbar sind. Dadurch ist eine Anpassung der thermoelektrischen Vorrichtung an vorher festgelegte Leistungsanforderungen möglich. Dies hat insbesondere Vorteile für die Herstellung und Bereitstellung von thermoelektrischen Vorrichtungen für die unterschiedlichen Anwendungsfälle. Dabei werden die Module untereinander insbesondere zumindest durch eine Lotverbindung miteinander verbunden, wobei insbesondere voneinander isolierte elektrische Leiterbahnen vorzusehen sind, die eine elektrische Reihenschaltung der Halbleiterelemente der einzelnen Module ermöglichen. Insbesondere ist dabei auch eine fluiddichte Verbindung der einzelnen Module untereinander zu erzeugen, so dass insbesondere korrosiv wirkende Umgebungsmedien, z.B. ein Abgas, nicht in die Bereiche zwischen zwei Modulen eindringen können. Für diese Verbindung von zumindest einer Mehrzahl von Modulen ist insbesondere eine rohrförmige Ausgestaltung der Module zu bevorzugen.

In vorteilhafterweise kann ein Modul einen Füllstoff aufweisen, der den Zwischenraum zwischen den Trägerschichten gegenüber Umgebungsmedien bzw. Fluiden, insbesondere einem Kühlkreislauf oder einem Abgas, abdichtet. Insbesondere können auch die Trägerschichten den Zwischenraum abdichten, indem die erste Trägerschicht und die zweite Trägerschicht eine (direkte) Verbindung miteinander ausbilden. Bei einer Anordnung mehrerer Module hintereinander werden aber bevorzugt erste Trägerschichten mit ersten Trägerschichten und/oder zweite Trägerschichten mit zweiten Trägerschichten verbunden, so dass die elektrischen Leiterbahnen innerhalb jedes einzelnen Moduls mit den Leiterbahnen des benachbarten Moduls verbindbar sind, ohne dass eine Trägerschicht durch eine Leiterbahn durchdrungen werden muss.

Gemäß einer weiteren vorteilhaften Ausgestaltung weist ein thermoelektrischer Apparat eine Mehrzahl von erfindungsgemäßen thermoelektrischen Vorrichtungen auf, wobei die erste Trägerschicht mit einer Heißseite und die zweite Trägerschicht mit einer Kaltseite verbunden ist.

Ganz besonders bevorzugt wird hier ein Kraftfahrzeug mit einem Verbrennungsmotor, einer Abgasanlage, einem Kühlkreislauf und einer Mehrzahl von erfindungsgemäßen thermoelektrischen Vorrichtungen vorgesehen, wobei die erste Trägerschicht mit einer Heißseite und die zweite Trägerschicht mit einer Kaltseite verbunden sind und wobei bei dem Kraftfahrzeug die Abgasanlage mit der Heißseite und der Kühlkreislauf mit der Kaltseite verbunden ist.

Die Erfindung sowie das technische Umfeld werden nachfolgend anhand der Figuren näher erläutert. Es ist darauf hinzuweisen, dass die Figuren besonders bevorzugte Ausführungsvarianten der Erfindung aufzeigen, diese jedoch nicht darauf beschränkt ist. Es zeigen schematisch:
- Fig. 1:: eine Ausführungsvariante eines thermoelektrischen Apparates in einem Kraftfahrzeug;
- Fig. 2:: eine Ausführungsvariante eines Moduls einer thermoelektrischen Vorrichtung;
- Fig. 3:: eine Ausführungsvariante eines Halbleiterelementes;
- Fig. 4:: eine weitere Ausführungsvariante eines Moduls einer thermoelektrischen Vorrichtung;
- Fig. 5:: eine weitere Ausführungsvariante eines Halbleiterelementes;
- Fig. 6:: eine Ausführungsvariante einer thermoelektrischen Vorrichtung; und
- Fig. 7:: ein Detail einer Ausführungsvariante eines Moduls.

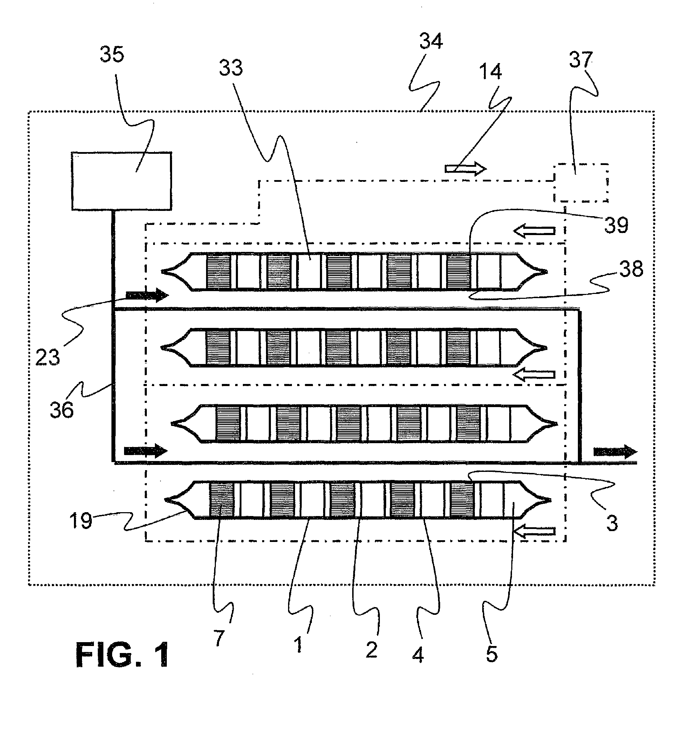

Fig. 1 zeigt eine Ausführungsvariante eines thermoelektrischen Apparates 33 in einem Kraftfahrzeug 34 mit einem Verbrennungsmotor 35 und einer Abgasanlage 36, in der ein zweites Fluid 23, insbesondere ein Abgas, mit einer erhöhten Temperatur durch den thermoelektrischen Apparat 33 hindurchströmt. Der thermoelektrische Apparat 33 weist eine Vielzahl von thermoelektrischen Vorrichtungen 1 mit Modulen 2 auf. Diese Module 2 werden auf einer Heißseite 38 von dem zweiten Fluid 23 überströmt und auf einer Kaltseite 39 von einem ersten Fluid 14, das einem Kühlreislauf 37 zugeordnet ist. Die Heißseite 38 der thermoelektrischen Vorrichtung 1 wird durch eine erste Trägerschicht 3 des Moduls 2 begrenzt. Ebenso wird die Kaltseite 39 durch eine zweite Trägerschicht 4 des Moduls 2 begrenzt. In dem Zwischenraum 5 zwischen erster Trägerschicht 3 und zweiter Trägerschicht 4 sind Halbleiterelemente 7 angeordnet. Weiterhin ist in Fig. 1 das gekapselte Volumen 19 eines Moduls 2 gezeigt, das hier durch die erste Trägerschicht 3 und die zweite Trägerschicht 4 begrenzt bzw. eingeschlossen wird.

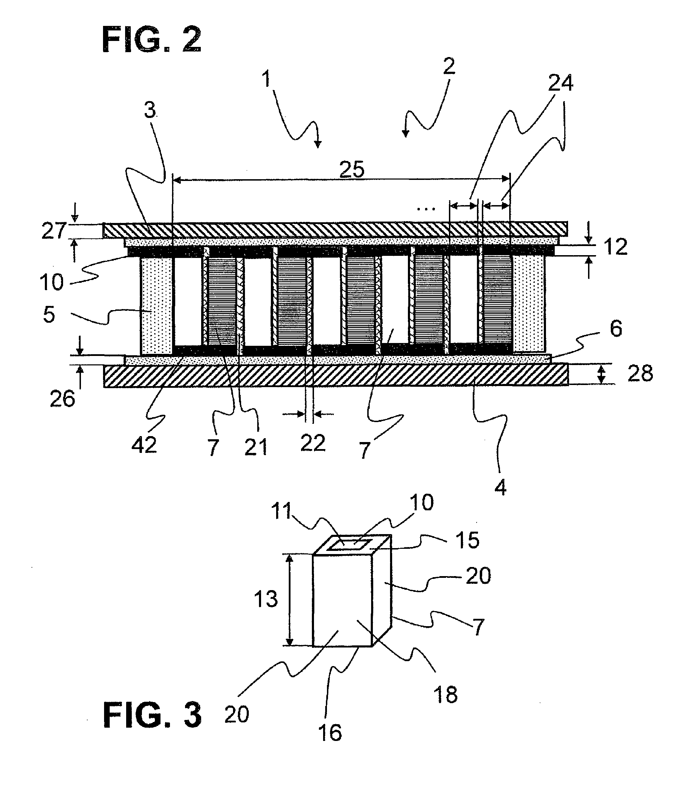

Fig. 2 zeigt ein Detail einer Ausführungsvariante eines Moduls 2 einer thermoelektrischen Vorrichtung 1. Dabei ist das Modul 2 dargestellt mit einer ersten Trägerschicht 3 und einer zweiten Trägerschicht 4, die zwischen sich einen Zwischenraum 5 aufweisen, in dem die Halbleiterelemente 7 wechselweise als n- und p-dotierte Halbleiterelemente angeordnet sind. Diese Halbleiterelemente 7 sind wechselweise elektrisch miteinander durch Lotmaterial 10 verbunden, so dass sich eine Reihenschaltung der n- und p-dotierten Halbleiterelemente ergibt. Das Lotmaterial 10 weist hier eine Lotdicke 12 auf. Das Lotmaterial 10 ist gegenüber der ersten Trägerschicht 3 bzw. zweiten Trägerschicht 4 durch eine elektrische Isolationsschicht 6 beabstandet, die eine Isolationsschichtdicke 26 aufweist. Die erste Trägerschicht 3 weist hier eine erste Dicke 27 auf, die insbesondere geringer ausgeführt ist als eine zweite Dicke 28 der zweiten Trägerschicht 4. Zwischen den Halbleiterelementen 7 ist eine Isolierung 21 mit einer Isolierungsweite 22 angeordnet, die einen Übertritt der die Halbleiterelemente 7 durchströmenden Elektronen verhindern soll und dementsprechend die Reihenschaltung der Halbleiterelemente 7 nur über das die Leiterbahnen 42 bildende Lotmaterial 10 gewährleistet. Weiter weist das Modul 2 eine mit Halbleiterelementen 7 beschichtbare Gesamtfläche 25 auf, die durch die äußersten Halbleiterelemente 7 begrenzt wird. Demgegenüber ist die beschichtete Fläche 24 die Summe der Flächenanteile des Moduls 2, die mit Halbleiterelementen 7 beschichtet ist.

Fig. 3 zeigt eine Ausführungsvariante eines Halbleiterelementes 7. Dieses ist hier quaderförmig bzw. stäbchenförmig ausgeführt und weist eine erste Kontaktfläche 15 und eine zweite Kontaktfläche 16 auf, über die das Halbleiterelement 7 mit der ersten Trägerschicht bzw. zweiten Trägerschicht über die elektrische Isolierungsschicht verbunden ist. Weiter weist das Halbleiterelement 7 eine Stromübergangsfläche 11 auf, die durch die Kontaktierung des Halbleiterelementes 7 mit Lotmaterial 10 gebildet wird, durch die die einzelnen Halbleiterelemente innerhalb des Moduls in einer Reihenschaltung miteinander verbunden werden. Das Halbleiterelement 7 weist zudem Seitenflächen 20 auf, die zusammen mit der ersten und zweiten Kontaktfläche 15, 16 das Volumen 18 des Halbleiterelements 7 begrenzen. Das Halbleiterelement 7 weist zudem eine Höhe 13 auf.

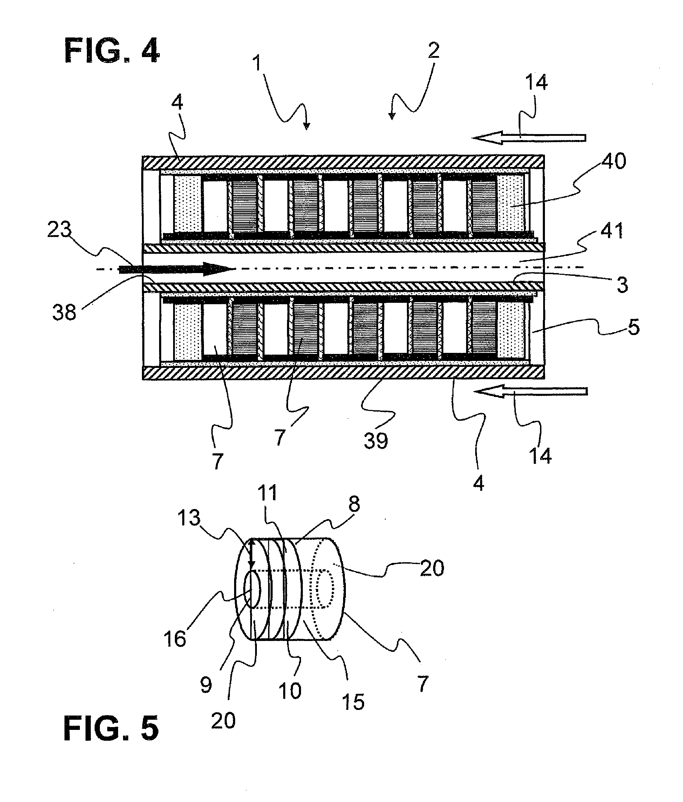

Fig. 4 zeigt eine weitere Ausführungsvariante eines Moduls 2 einer thermoelektrischen Vorrichtung 1, wobei hier eine rohrförmige Ausführung der thermoelektrischen Vorrichtung 1 bzw. des Moduls 2 gezeigt ist. Das rohrförmige Modul 2 wird durch einen inneren Kanal 41 insbesondere von einem zweiten Fluid 23 durchströmt. Damit bildet in der hier gezeigten Ausführungsvariante der innere Kanal 41 die Heißseite 38 der thermoelektrischen Vorrichtung 1. Die Kaltseite 39 der thermoelektrischen Vorrichtung 1 wird von einem ersten Fluid 14 überströmt, so dass sich über die Halbleiterelemente 7 ein Temperaturpotential bildet. Die innere Umfangsfläche des Rohres und damit der innere Kanal 41 wird durch die erste Trägerschicht 3 gebildet, während die äußere Umfangsfläche des Moduls 2 hier durch die zweite Trägerschicht 4 gebildet wird. Zur Begrenzung des Zwischenraums 5 und zum Schutz vor dem Eindringen vor ggf. korrosiv wirkenden Fluiden ist der Zwischenraum 5 durch ein Füllmaterial 40 abgedichtet.

Fig. 5 zeigt eine weitere Ausführungsvariante eines Halbleiterelementes 7. Dabei ist hier ein ringförmiges Halbleiterelement 7 gezeigt mit einer äußeren Umfangsfläche 8 und einer inneren Umfangsfläche 9. Dieses Halbleiterelement 7 ist insbesondere geeignet zum Einsatz in einer rohrförmigen thermoelektrischen Vorrichtung z. B. gemäß Fig. 4. Das Halbleiterelement 7 ist dabei über eine erste Kontaktfläche 15 mit der ersten Trägerschicht und mit einer zweiten Kontaktfläche 16 mit einer zweiten Trägerschicht verbunden. Das Halbleiterelement 7 weist weiterhin Seitenflächen 20 sowie eine Höhe 13 auf, die sich zwischen der inneren Umfangsfläche 9 und der äußeren Umfangsfläche 8 ausbildet. Das ringförmige Halbleiterelement 7 weist eine Stromübergangsfläche 11 auf seiner äußeren Umfangsfläche 15 und eine weitere Stromübergangsfläche auf seiner inneren Umfangsfläche 16 auf, die durch die Kontaktierung mit Lotmaterial 10 gebildet wird.

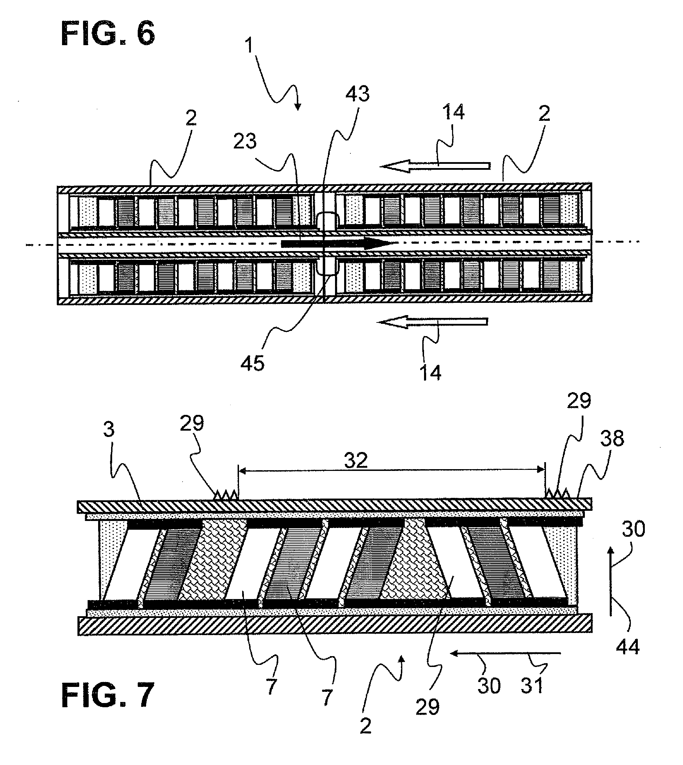

Fig. 6 zeigt eine Ausführungsvariante einer thermoelektrischen Vorrichtung 1, wobei mehrere Module 2 zu einer thermoelektrischen Vorrichtung 1 miteinander durch Lötverbindungen 43 verbunden sind. Dabei ist insbesondere eine Abdichtung der einzelnen Module 2 gegenüber ggf. korrosiv wirkenden Fluiden zu gewährleisten. Hier sind mehrere Module 2 zu einer thermoelektrischen Vorrichtung 1 verbunden, so dass die thermoelektrische Vorrichtung 1 an unterschiedlichste Anforderungen hinsichtlich der Bereitstellung von elektrischer Energie bzw. Umwandlung von vorhandener thermischer Energie in elektrische Energie angepasst werden kann. Die einzelnen Module 2 sind über Verbindungsmittel 45 miteinander elektrisch verbunden, so dass eine Reihenschaltung der Halbleiterelemente auch über mehrere Module 2 innerhalb der thermoelektrischen Vorrichtung 1 gewährleistet ist.

Fig. 7 zeigt ein Detail einer bevorzugten Ausführungsvariante eines Moduls 2, wobei hier gegenüber einer axialen Richtung 31 schräggestellte Halbleiterelemente 7 vorgesehen sind, die ein axiales Kompensationselement 29 bilden, so dass eine Wärmeausdehnung 30 in der axialen Richtung 31 durch Veränderung der Schrägstellung der Halbleiterelemente 7 in eine Wärmeausdehnung 30 in radialer Richtung 44 zumindest teilweise umgewandelt werden kann. Weiter sind axiale Kompensationselemente 29 auf der ersten Trägerschicht 3 (Heißseite 38) vorgesehen, die in einem Abstand 32 zueinander angeordnet sind.

### Bezugszeichenliste

- 1: Thermoelektrische Vorrichtung
- 2: Modul
- 3: Erste Trägerschicht (Heißseite)
- 4: Zweite Trägerschicht (Kaltseite)
- 5: Zwischenraum
- 6: Isolationsschicht
- 7: Halbleiterelement
- 8: Äußere Umfangsfläche
- 9: Innere Umfangsfläche
- 10: Lotmaterial
- 11: Stromübergangsfläche
- 12: Lotdicke
- 13: Höhe
- 14: Erstes Fluid
- 15: Erste Kontaktfläche
- 16: Zweite Kontaktfläche
- 17: Nutzvolumen
- 18: Volumen
- 19: Gekapseltes Volumen
- 20: Seitenfläche
- 21: Isolierung
- 22: Isolierungsweite
- 23: Zweites Fluid
- 24: Beschichtete Fläche
- 25: Beschichtbare Gesamtfläche
- 26: Isolationsschichtdicke
- 27: Erste Dicke
- 28: Zweite Dicke
- 29: Axiales Kompensationselement
- 30: Wärmeausdehnung
- 31: Axiale Richtung
- 32: Abstand
- 33: Thermoelektrischer Generator
- 34: Kraftfahrzeug
- 35: Verbrennungsmotor
- 36: Abgasanlage
- 37: Kühlkreislauf
- 38: Heißseite
- 39: Kaltseite
- 40: Füllmaterial
- 41: Innerer Kanal
- 42: Leiterbahn
- 43: Lotverbindung
- 44: Radiale Richtung
- 45: Anschlusselemente

## Patentansprüche

1. Thermoelektrische Vorrichtung (1) zumindest aufweisend
- wenigstens ein Modul (2) mit einer ersten Trägerschicht (3) und einer zweiten Trägerschicht (4),
- einen Zwischenraum (5) zwischen der ersten Trägerschicht (3) und der zweiten Trägerschicht (4),
- eine elektrische Isolationsschicht (6) auf der ersten Trägerschicht (3) und auf der zweiten Trägerschicht (4) hin zum Zwischenraum (5),
- eine Mehrzahl von p- und n-dotierten Halbleiterelementen (7), die im Zwischenraum (5) zwischen den Isolationsschichten (6) abwechselnd angeordnet und wechselweise elektrisch miteinander verbunden sind,
**dadurch gekennzeichnet, dass** die Halbleiterelemente (7) kreisringförmig ausgestaltet sind und mit einer äußeren Umfangsfläche (8) und einer inneren Umfangsfläche (9) mit der elektrischen Isolationsschicht (6) verbunden sind, und wobei die p- und n-dotierten Halbleiterelemente (7) auf der elektrischen Isolationsschicht (6) durch ein Lotmaterial (10) miteinander elektrisch verbunden sind und die p- und n-dotierten Halbleiterelemente (7) jeweils gleich große Stromübergangsflächen (11) aufweisen.

2. Thermoelektrische Vorrichtung (1) gemäß Patentanspruch 1, wobei das Material für die wenigstens eine Trägerschicht (3, 4) Kunststoff umfasst.

3. Thermoelektrische Vorrichtung (1) gemäß einem der vorhergehenden Patentansprüche, wobei die p- und n-dotierten Halbleiterelemente (7) auf der elektrischen Isolationsschicht (6) durch ein Lotmaterial (10) miteinander elektrisch verbunden sind und zumindest eine der folgenden Bedingungen erfüllt ist,
b) das Lotmaterial (10) weist eine Lotdicke (12) auf und das Verhältnis von einer Höhe (13) der Halbleiterelemente (7) zu der Lotdicke (12) ist größer als 5 : 1;
c) das Lotmaterial (10) ist ein Element aus der Gruppe Aktivlot, Silberlot.

4. Thermoelektrische Vorrichtung (1) gemäß einem der vorhergehenden Patentansprüche, wobei ein Nutzvolumen (17) des Moduls (2) als Verhältnis der Summe der Volumen (18) der Halbleiterelemente (7) in dem Modul (2) zu einem gekapselten Volumen (19) des Moduls (2) definiert ist und das Nutzvolumen (17) größer 90 % ist.

5. Thermoelektrische Vorrichtung (1) gemäß einem der vorhergehenden Patentansprüche, wobei die Halbleiterelemente (7) an einander zugewandten Seitenflächen (20) eine elektrische Isolierung (21) aufweisen, wobei die elektrische Isolierung (21) insbesondere durch eine Schicht aus Glimmer oder Keramik gebildet wird.

6. Thermoelektrische Vorrichtung (1) gemäß einem der vorhergehenden Patentansprüche, wobei das Verhältnis einer Höhe (13) der Halbleiterelemente (7) zu einer Isolationsschichtdicke (26) der elektrischen Isolationsschicht (6) größer als 8 : 1 ist.

7. Thermoelektrische Vorrichtung (1) gemäß einem der vorhergehenden Patentansprüche, wobei die erste Trägerschicht (3) zumindest ein axiales Kompensationselement (29) aufweist, das eine Wärmeausdehnung (30) des Moduls (2) in einer axialen Richtung (31) ausgleicht.

8. Thermoelektrische Vorrichtung (1) gemäß einem der vorhergehenden Patentansprüche, wobei das wenigstens eine Modul (2) zumindest ein axiales Kompensationselement (29) aufweist, das durch zumindest mehrere in einer axialen Richtung (31) schräg angeordnete Halbleiterelemente (7) gebildet wird, so dass eine Wärmeausdehnung (30) des Moduls (2) in einer axialen Richtung (31) zumindest teilweise in eine Wärmeausdehnung (30) in einer radialen Richtung (44) umgewandelt wird.

9. Kraftfahrzeug (34) mit einem Verbrennungsmotor (35), einer Abgasanlage (36), einem Kühlkreislauf (37) und einer Mehrzahl von Thermoelektrischen Vorrichtungen (1) gemäß einem der vorhergehenden Patentansprüche, wobei die erste Trägerschicht (3) mit einer Heißseite (38) und die zweite Trägerschicht (4) mit einer Kaltseite (39) verbunden ist und wobei bei dem Kraftfahrzeug (34) die Abgasanlage (36) mit der Heißseite (38) und der Kühlkreislauf (37) mit der Kaltseite (39) verbunden ist.

## Claims

1. Thermoelectric device (1) at least comprising
- at least one module (2) having a first carrier layer (3) and a second carrier layer (4),
- an interspace (5) between the first carrier layer (3) and the second carrier layer (4),
- an electrical insulation layer (6) on the first carrier layer (3) and on the second carrier layer (4) toward the interspace (5),
- a plurality of p- and n-doped semiconductor elements (7), which are arranged alternately in the interspace (5) between the insulation layers (6) and are alternately electrically connected to one another
**characterized in that** the semiconductor elements (7) are configured in annular fashion and are connected to the electrical insulation layer (6) by an outer circumferential area (8) and an inner circumferential area (9) and wherein the p- and n-doped semiconductor elements (7) are electrically connected to one another by means of a solder material (10) on the electrical insulation layer (6) and the p- and n-doped semiconductor elements (7) each have current transfer areas (11) of the same size.

2. Thermoelectric device (1) as claimed in claim 1, wherein the material for the at least one carrier layer (3, 4) comprises plastic.

3. Thermoelectric device (1) as claimed in any of the preceding claims, wherein the p- and n-doped semiconductor elements (7) are electrically connected to one another by means of a solder material (10) on the electrical insulation layer (6) and at least one of the following conditions is met,
b) the solder material (10) has a solder thickness (12) and the ratio of a height (13) of the semiconductor elements (7) to the solder thickness (12) is greater than 5:1;
c) the solder material (10) is an element from the group active solder, silver solder.

4. Thermoelectric device (1) as claimed in any of the preceding claims, wherein a useful volume (17) of the module (2) is defined as a ratio of the sum of the volume (18) of the semiconductor elements (7) in the module (2) to an encapsulated volume (19) of the module (2) and the useful volume (17) is greater than 90%.

5. Thermoelectric device (1) as claimed in any of the preceding claims, wherein the semiconductor elements (7) have an electrical insulation (21) on side areas (20) facing one another, wherein the electrical insulation (21) is formed, in particular, by a layer composed of mica or ceramic.

6. Thermoelectric device (1) as claimed in any of the preceding claims, wherein the ratio of a height (13) of the semiconductor elements (7) to an insulation layer thickness (26) of the electrical insulation layer (6) is greater than 8:1.

7. Thermoelectric device (1) as claimed in any of the preceding claims, wherein the first carrier layer (3) has at least one axial compensation element (29) which compensates for a thermal expansion (30) of the module (2) in an axial direction (31).

8. Thermoelectric device (1) as claimed in any of the preceding claims, wherein the at least one module (2) has at least one axial compensation element (29) which is formed by at least a plurality of semiconductor elements (7) arranged obliquely in an axial direction (31), such that a thermal expansion (30) of the module (2) in an axial direction (31) is at least partly converted into a thermal expansion (30) in a radial direction (44).

9. Motor vehicle (34) comprising an internal combustion engine (35), an exhaust gas system (36), a cooling circuit (37) and a plurality of thermoelectric devices (1) as claimed in any of the preceding claims, wherein the first carrier layer (3) is connected to a hot side (38) and the second carrier layer (4) is connected to a cold side (39), and wherein, in the motor vehicle (34), the exhaust gas system (36) is connected to the hot side (38) and the cooling circuit (37) is connected to the cold side (39).

## Revendications

1. Dispositif thermoélectrique (1) présentant au moins
- au moins un module (2) avec une première couche de support (3) et une deuxième couche de support (4),
- une chambre intermédiaire (5) entre la première couche de support (3) et la deuxième couche de support (4),
- une couche d'isolation électrique (6) sur la première couche de support (3) et sur la deuxième couche de support (4) du côté de la chambre intermédiaire (5),
- une multiplicité d'éléments semi-conducteurs (7) à dopage p et n, qui sont disposés en alternance dans l'espace intermédiaire (5) entes les couches d'isolation (6) et qui sont alternativement reliés électriquement les uns aux autres,
**caractérisé en ce que** les éléments semi-conducteurs (7) sont réalisés en forme d'anneaux circulaires et sont reliés par une surface périphérique extérieure (8) et par une surface périphérique intérieure (9) à la couche d'isolation électrique (6) et dans lequel les éléments semi-conducteurs (7) à dopage p et n sont reliés électriquement les uns aux autres par une matière de brasage (10) sur la couche d'isolation électrique (6) et les éléments semi-conducteurs (7) à dopage p et n présentent respectivement des faces de transfert de courant d'égale grandeur (11).

2. Dispositif thermoélectrique (1) selon la revendication 1, dans lequel le matériau pour ladite au moins une couche de support (3, 4) comprend de la matière synthétique.

3. Dispositif thermoélectrique (1) selon l'une quelconque des revendications précédentes, dans lequel les éléments semi-conducteurs (7) à dopage p et n sont reliés électriquement les uns aux autres par une matière de brasage (10) sur la couche d'isolation électrique (6) et au moins une des conditions suivantes est remplie:
b) la matière de brasage (10) présente une épaisseur de brasure (12) et le rapport d'une hauteur (13) des éléments semi-conducteurs (7) à l'épaisseur de brasure (12) est supérieur à 5:1;
c) la matière de brasage (10) est un élément du groupe brasure active, brasure à l'argent.

4. Dispositif thermoélectrique (1) selon l'une quelconque des revendications précédentes, dans lequel un volume utile (17) du module (2) est défini comme le rapport de la somme des volumes (18) des éléments semi-conducteurs (7) dans le module (2) à un volume capsulé (19) du module (2) et le volume utile (17) est supérieur à 90 %.

5. Dispositif thermoélectrique (1) selon l'une quelconque des revendications précédentes, dans lequel les éléments semi-conducteurs (7) présentent un isolant électrique (21) sur des faces latérales (20) tournées l'une vers l'autre, dans lequel l'isolant électrique (21) est formé en particulier par une couche de mica ou de céramique.

6. Dispositif thermoélectrique (1) selon l'une quelconque des revendications précédentes, dans lequel le rapport d'une hauteur (13) des éléments semi-conducteurs (7) à une épaisseur de couche d'isolation (26) de la couche d'isolation électrique (6) est supérieur à 8:1.

7. Dispositif thermoélectrique (1) selon l'une quelconque des revendications précédentes, dans lequel la première couche de support (3) présente au moins un élément de compensation axial (29), qui compense une dilatation thermique (30) du module (2) dans une direction axiale (31).

8. Dispositif thermoélectrique (1) selon l'une quelconque des revendications précédentes, dans lequel ledit au moins un module (2) présente au moins un élément de compensation axial (29), qui est formé par au moins plusieurs éléments semi-conducteurs (7) disposés en oblique dans une direction axiale (31), de telle manière qu'une dilatation thermique (30) du module (2) dans une direction axiale (31) soit convertie au moins partiellement en une dilatation thermique (30) dans une direction radiale (44).

9. Véhicule automobile (34) comportant un moteur à combustion interne (35), une installation de gaz d'échappement (36), un circuit de refroidissement (37) et une multiplicité de dispositifs thermoélectriques (1) selon l'une quelconque des revendications précédentes, dans lequel la première couche de support (3) est reliée à un côté chaud (38) et la deuxième couche de support (4) est reliée à un côté froid (39) et dans lequel, dans le véhicule automobile (34), l'installation de gaz d'échappement (36) est reliée au côté chaud (38) et le circuit de refroidissement (37) est relié au côté froid (39).
